# EUROPÄISCHE PATENTANMELDUNG

(11) **EP 1 096 503 A1**
(43) Veröffentlichungstag der Anmeldung: **02.05.2001**
(21) Anmeldenummer: 00119545.2
(22) Anmeldetag: 07.09.2000
(51) Int. Cl.: G11C 14/00, G11C 16/04

(54) **Elektrisch lösch- und programmierbare nichtflüchtige Speicheranordnung mit parallel geschalteter bistabiler Kippstufe**

(30) Priorität: 27.10.1999 DE 19951818
(71) Anmelder: Micronas GmbH, 79108 Freiburg (DE)
(72) Erfinder: Ullrich, Manfred, Dipl.-Ing., 79211 Denzlingen (DE)
(74) Vertreter: Patentanwälte Westphal, Mussgnug & Partner

(57) **Zusammenfassung**

Die Speicheranordnung umfaßt mindestens eine elektrisch lösch- und programmierbare nichtflüchtige Speicherzelle (1, 5, 9, 14), eine der Speicherzelle parallel geschaltete bistabile Kippstufe (13) und eine mit der Kippstufe (13) verbundene Schalteinrichtung (22) zum Aufschalten mindestens einer Dateneingangsleitung (DI) auf eine der Zustandsleitungen (QP, QN) der Kippstufe (13) in Abhängigkeit von einem Schaltsignal (LC);

## Beschreibung

Die Erfindung betrifft eine elektrisch lösch- und programmierbare nichtflüchtige Speicheranordnung.

Bei zahlreichen Anwendungen wie beispielsweise bei tragbaren Datenträgern (Chipkarten), mobiler Datenverarbeitung, drahtloser Daten- und Energieübertragung, sicherheitsrelevanten Einrichtungen und Kraftfahrzeugen ist es notwendig, Daten so zu speichern, daß diese auch bei Abschaltung oder Ausfall der Stromversorgung erhalten bleiben. Neben einer hohen Aufwand, viel Raum und viel Energie erfordernden Speicherung der Daten auf Magnetträgern werden dafür vor allem aber auch elektrisch lösch- und programmierbare nichtflüchtige Halbleiterspeicher verwendet.

Bei den derzeit gebräuchlichen elektrisch lösch- und programmierbaren nichtflüchtigen Halbleiterspeichern können zwei Arten unterschieden werden: EEPROMs (Electrically Erasable and Programmable Read Only Memeories) und Flash-EPROMs (gelegentlich auch Flash-EEPROMs genannt). EEPROMs nutzen den bekannten Fowler-Nordheim-Tunneleffekt zum Löschen und Programmieren, während Flash-EPROMs sich zum Programmieren der Heiße-Elektronen-Injektion und zum Löschen des Fowler-Nordheim-Tunneleffekts bedienen. Gemeinsam ist beiden in der Regel, daß sie mindestens zwei Transistoren aufweisen, von denen einer ein Floating-Gate aufweist. Das Floating-Gate ist dabei mit einer Tunneldiodenanordnung gekoppelt, um den zugehörigen Transistor bei Bedarf zu laden. Darüber hinaus dient mindestens ein weiterer Transistor dazu, die Zelle zu aktivieren beziehungsweise aus zuwählen.

Sowohl EEPROMs als auch Flash-EPROMs benötigen jedoch eine verhältnismäßig lange Zeit zum Programmieren. Sie lassen zudem auch nur eine begrenzte Anzahl von Programmiervorgängen zu und weisen eine im Vergleich zu anderen Halbleiterspeichern höhere Ausfallhäufigkeit auf. Daher sind EEPROMs und Flash-EPROMs nur bedingt für sicherheitsrelevante Anwendungen geeignet.

Aufgabe der Erfindung ist es daher, eine elektrisch lösch- und programmierbare nichtflüchtige Speicheranordnung anzugeben, die diese Nachteile nicht aufweist.

Die Aufgabe wird durch eine Speicheranordnung gemäß dem unabhängigen Patentanspruch 1 gelöst. Ausgestaltungen und Weiterbildungen der Erfindung sind Gegenstand von abhängigen Ansprüchen.

Vorteilhafterweise sind bei der erfindungsgemäßen Speicheranordnung die Ausgänge ohne wesentliche Verzögerung und ständig gültig, denn die Ausgänge erhalten schon vor dem eigentlichen Programmieren die Daten, so daß deren Auswirkungen auf weitere Schaltungsteile vor dem eigentlichen Programmieren getestet und diese gegebenfalls noch vor dem Programmieren geändert werden können. Damit wird unnötiges Umprogrammieren und damit eine unnötige Verkürzung der Lebensdauer der Speicheranordnung verhindert.

Erreicht wird dies durch eine elektrisch lösch- und programmierbare nichtflüchtige Speicheranordnung mit einer ersten elektrisch lösch- und programmierbaren nichtflüchtigen Speicherzelle, die eine Bitleitung, eine Auswahlleitung, eine Programmierleitung und eine Löschleitung aufweist und mit zudem einer bistabilen Kippstufe mit zwei zueinander inversen Zustandsleitungen, von denen die eine mit der Bitleitung der Speicherzelle und die andere mit der Programmierleitung der Speicherzelle verbunden ist. Weiterhin umfaßt die erfindungsgemäße Speicheranordnung eine mit der Kippstufe verbundene Schalteinrichtung zum Aufschalten mindestens einer Dateneingangsleitung (beispielsweise zweier zueinander inverser Dateneingangsleitungen) auf die Zustandsleitung(en) der Kippstufe in Abhängigkeit von einem Schaltsignal.

Dabei werden zum Laden der Speicheranordnung die Dateneingangsleitung(en) auf die Bitleitung(en) aufgeschaltet und die Kippstufe mit einer niedrigen Spannung gespeist. Zum Löschen der Speicheranordnung wird die Kippstufe mit einer höheren Spannung gespeist und die Löschleitung der Speicherzelle mit der höheren Spannung angesteuert. Zum Programmieren der Speicheranordnung wird die Kippstufe mit der höheren Spannung gespeist. Zum Lesen der Speicheranordnung wird schließlich die Kippstufe mit der niedrigeren Spannung gespeist und die Auswahlleitung der Speicherzelle mit der niedrigeren Spannung angesteuert.

Bei einer bevorzugten Ausführungsform einer erfindungsgemäßen Speicheranordnung ist eine zweite elektrisch lösch- und programmierbare nichtflüchtige Speicherzelle vorgesehen. Die Bitleitung und die Löschleitung der zweiten Speicherzelle sind mit der Bitleitung beziehungsweise der Löschleitung der ersten Speicherzelle verbunden. Die Auswahlleitung der zweiten Speicherzelle wird zum Laden, Löschen, Programmieren und Lesen der Speicheranordnung wie die erste Speicherzelle angesteuert. Durch eine zweite Speicherzelle wird die Redundanz und damit die Sicherheit der gesamten Anordnung gegenüber Ausfällen einer Speicherzelle erhöht.

Weiterhin kann mindestens eine weitere elektrisch lösch- und programmierbare nichtflüchtige Speicherzelle vorgesehen werden. Die Bitleitung und die Löschleitung der weiteren Speicherzelle(n) sind mit der Löschleitung beziehungsweise der Bitleitung der ersten Speicherzelle verbunden sind. Die Ansteuerung der weiteren Speicherzelle(n) ist beim Laden und Lesen der Speicheranordnung gleich der jeweiligen Ansteuerung der ersten Zelle und beim Löschen und Programmieren der Speicheranordnung gleich der Ansteuerung der ersten Speicherzelle beim Programmieren beziehungsweise Löschen der Speicheranordnung. Diese Maßnahme hat eine weitere Erhöhung der Redundanz und somit der Sicherheit zur Folge, wobei durch die inverse Ansteuerung der mindestens einen weiteren Speicherzelle auch ein systematischer Fehler auf beiden Seiten der bistabilen Kippstufe erkannt und behoben werden kann. Zum Überprüfen der Zustände der einzelnen Speicherzellen werden bevorzugt die Auswahleitungen der Speicherzellen auch einzeln angesteuert.

Darüber hinaus können zum Testen der Speicheranordnung beispielsweise durch entsprechende Ansteuerung der Dateneingangsleitungen bei entsprechendem Schaltsignal alle Speicherzellen in den gleichen Zustand gebracht werden und danach einzeln ausgelesen werden. Damit läßt sich die Funktionsfähigkeit jeder Speicherzelle vor und nach dem Löschen und/oder Programmieren ermitteln. Zum Programmieren wird/werden dabei bevorzugt die Auswahlleitung(en) der Speicherzelle(n) nicht angesteuert.

Es kann weiterhin eine Schalteinrichtung zum Aufschalten der Dateneingangsleitungen auf die Zustandsleitungen der Kippstufe vorgesehen werden, die bei Nicht-Auftreten des Schaltsignals einen hochohmigen Zustand annimmt. Derartige Schalteinrichtungen können somit beispielsweise einen sogenannten Tri-State-Ausgang aufweisen. Auf dies Weise läßt sich ohne größeren Aufwand ein steuerbarer Schalter für Datenleitungen realisieren.

Bei einer bevorzugten Ausführungsform einer erfindungsgemäßen Speicheranordnung weist mindestens eine Speicherzelle einen Floating-Gate-Transistor auf, dessen Source-Anschluß an ein Bezugspunkt angeschlossen ist, dessen Drain-Anschluß über die gesteuerte Strecke eines Auswahl-Transistors mit der Bitleitung verbunden ist und dessen Gate-Anschluß zum einen über eine Tunnel-Kapazität mit der Löschleitung und zum anderen über die Gate-Source-Strecke eines Injektor-Transistors mit der Programmierleitung gekoppelt ist. Dadurch wird mit geringern Aufwand eine zuverlässige Flash-EPROM-Zelle geschaffen.

Des weiteren können insbesondere die bistabile Kippstufe und die Speicherzelle(n) einen gemeinsamen Bezugspunkt haben, wobei hier wie auch bei anderen Ausführungsformen zum Löschen und Programmieren der Speicheranordnung der Bezugspunkt verschoben werden kann, um andere Schaltungsteile zu schonen. Dabei wird bevorzugt mindestens an eine Zustandsleitung der Kippstufe angeschlossene Ausgangsschaltung vorgesehen, deren Querstrom sich vorteilhafterweise bei Anhebung des Bezugspunkts im wesentlichen nicht erhöht.

Dementsprechend kann auch eine Schalteinrichtung zum Aufschalten der Dateneingangsleitungen auf die Zustandsleitungen der Kippstufe vorgesehen werden, die Mittel zur Pegelwandlung und/oder Bezugspunktanpassung aufweist, um die Anhebung des Bezugspunkts im Hinblick auf die Dateneingangsleitungen zu kompensieren.

Die Erfindung wird nachfolgend anhand des in den Figuren der Zeichnung dargestellten Ausführungsbeispiels näher erläutert.
Es zeigt:
- Figur 1: eine Ausführungsform einer erfindungsgemäßen Speicheranordnung in einem Schaltbild,
- Figur 2: das logische Verhalten verschiedener Signale bei der Ausführungsform nach Figur 1 in einer Tabelle und
- Figur 3: den zeitlichen Verlauf zweier ausgewählter Signale während des Löschens und Programmierens bei der Ausführungsform nach Figur 1 in einem Diagrammm.

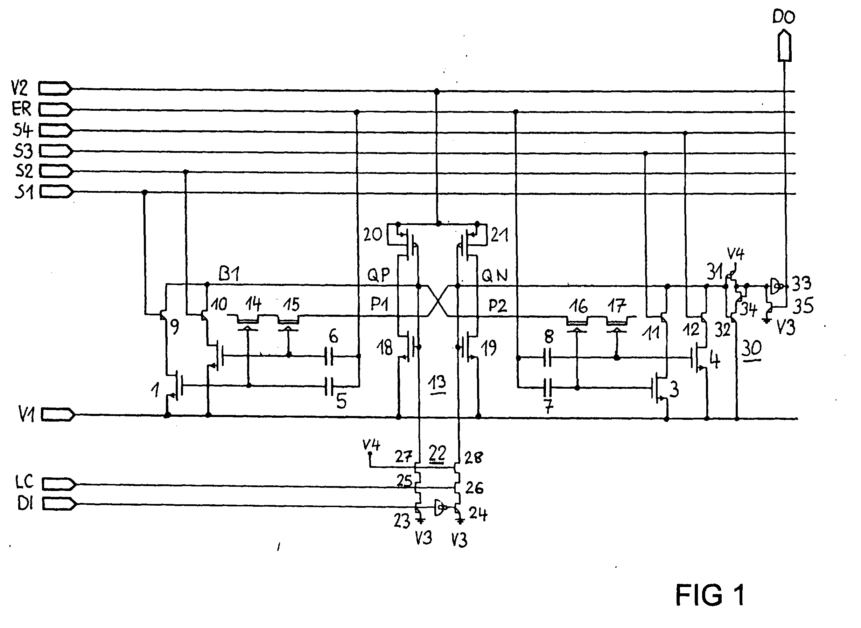

Bei der in Figur 1 gezeigten erfindungsgemäßen Speicheranordnung sind vier elektrisch lösch- und programmierbare nichtflüchtige Speicherzellen vorgesehen, die jeweils einen MOS-Feldefekttransistor 1, 2, 3, 4 mit Floating-Gate aufweisen. Die MOS-Feldefekttransistoren 1, 2, 3, 4 sind source-seitig mit einem ersten Versorgungsleitung V1 verbunden und gateseitig über jeweils eine Tunnel-Kapazität 5, 6, 7, 8 mit einer gemeinsamen Löschleitung ER gekoppelt.

Die Drain-Anschlüsse der MOS-Feldefekttransistoren 1, 2 sind über die gesteuerte Strecke jeweils eines Auswahltransistors 9, 10 zu einer gemeinsamen Bitleitung B1 verschaltet. Die Steueranschlüsse der Auswahltransistoren 9 und 10 sind jeweils an eine Auswahlleitung S1, S2 angeschlossen. Entsprechend sind bei den MOS-Feldeffekttransistoren 3 und 4 die Drain-Anschlüsse über die gesteuerte Strecke jeweils eines Auswahltransistors 11, 12 miteinander zu einer gemeinsamen Bitleitung B2 verschaltet. Die Steueranschlüsse der Auswahltransistoren 11 und 12 sind demgemäß jeweils an eine Auswahlleitung S3, S4 angeschlossen.

Die Gate-Anschlüsse der MOS-Feldefekttransistoren 1, 2 sind darüber hinaus jeweils mit Gate-Anschlüssen zweier Injektor-Transistoren 14, 15 zur Injektion heißer Elektronen in das jeweilige Floating-Gate verbunden, deren Source-Anschlüsse ihrerseits eine Programmierleitung P1 bildend mit der Bitleitung B2 gekoppelt sind. Umgekehrt sind die Gate-Anschlüsse der MOS-Feldefekttransistoren 3, 4 jeweils mit Gate-Anschlüssen zweier Injektor-Transistoren 16, 17 verbunden, deren Source-Anschlüsse ihrerseits eine Programmierleitung P2 bildend mit der Bitleitung B1 gekoppelt sind.

Die Bitleitungen B1 und B2 sind jeweils mit zueinander inversen Zustandsleitungen QP, QN eines Flip-Flops 13 verbunden. Das Flip-Flop 13 besteht aus zwei MOS-Feldeffekttransistoren 18, 19 vom n-Kanal-Typ, deren Source-Anschlüsse mit dem Versorgungsleitung V1 verschaltet sind und deren Gate-Anschlüsse mit den Drain-Anschlüsssen des jeweils anderen MOS-Feldeffekttransistors 19, 18 gekoppelt sind. Die Drain-Anschlüsse beider MOS-Feldeffekttransistoren 18, 19 sind darüber hinaus jeweils mit Drain-Anschlüsssen zweier MOS-Feldeffekttransistoren 20, 21 vom p-Kanal-Typ verschaltet, deren miteinander gekoppelte Source-Anschlüsse an ein Versorgungsleitung V2 angeschlossen sind. Dabei sind zudem die Gate-Anschlüsse der MOS-Feldeffekttransistoren 18 und 20 sowie die Gate-Anschlüsse der MOS-Feldeffekttransistoren 19 und 21 jeweils miteinander sowie mit den Drain-Anschlüssen der MOS-Feldeffekttransistoren 19 und 21 beziehungsweise der MOS-Feldeffekttransistoren 18 und 20 die Zustandsleitungen QN und QP ergebend gekoppelt.

Die gekoppelten Gate-Anschlüsse der MOS-Feldeffekttransistoren 18 und 20 einerseits sowie die gekoppelten Gate-Anschlüsse der MOS-Feldeffekttransistoren 19 und 21 andererseits sind jeweils mit den Ausgängen einer Schalteinrichtung 22 verbunden, die über eine Steuerleitung LC gesteuert wird und die eine Dateneingangsleitung DI nichtinvertiert und invertiert auf die gekoppelten Gate-Anschlüsse der MOS-Feldeffekttransistoren 18, 20 bzw. 19, 21 aufschaltet. Die Schalteinrichtung 22 besteht aus sechs Transistoren 23 bis 28, wobei die gesteuerten Strecken jeweils dreier Transistoren 23, 25, 27 bzw. 24, 26, 28 hintereinander und zwischen die gekoppelten Gate-Anschlüsse der MOS-Feldeffekttransistoren 18, 20 bzw. 19, 21 einerseits und ein Bezugspotential V3 andererseits geschaltet sind. Die Steueranschlüsse der dem Bezugspotential V3 am nächsten angeordneten Transistoren 23 und 24 sind mit der Dateneingangsleitung DI gekoppelt derart, daß der Steueranschluß des Transistors 23 direkt und der Steueranschluß des Transistors 24 unter Zwischenschaltung eines Inverters 29 mit der Dateneingangsleitung DI verbunden ist. Die Steueranschlüsse der den MOS-Feldeffekttransistoren 18, 19, 20 und 21 zugewandten Transistoren 27 und 28 sind an ein Versorgungsleitung V4 angeschlossen. Sie sorgen damit für ein gleichbleibendes Versorgungspotential für die jeweils anderen beiden Transistoren 23, 25 bzw. 24, 26. Die Steueranschlüsse der dazwischenliegenden Transistoren 25 und 26 sind miteinander sowie mit der Steuerleitung LC gekoppelt. Die Transistoren 25 und 26 bewirken das eigentliche Aufschalten der Dateneingangsleitung DI auf das Flip-Flop 13 und das damit verbundene Speichern des auf der Dateneingangsleitung DI auftretenden Zustands im Flip-Flop 13 (Setzen des Flip-Flops 13).

Schließlich ist der Bitleitung B2 bzw. der Zustandsleitung QN des Flip-Flops 13 eine Ausgangsstufe 30 nachgeschaltet. Die Ausgangsstufe 30 umfaßt zwei Transistoren 31 und 32, deren Steueranschlüsse mit der Bitleitung B2 bzw. der Zustandsleitung QN des Flip-Flops 13 verbunden sind. Die gesteuerte Strecke des Transistors 31 ist zwischen das Versorgungsleitung V4 und den Eingang eines Inverters 33 geschaltet. Die gesteuerte Strecke des Transistors 32 ist dagegen in Reihe zur gesteuerten Strecke eines Transistors 34 sowie zwischen das Versorgungsleitung V1 den Eingang des Inverters 33 geschaltet. Der Eingang des Inverters 33 ist zudem mit dem Steueranschluß des Transistors 34 verbunden und über die gesteuerte Strecke eines Transistors 35 mit dem Bezugspotential V3 gekoppelt. Der Steueranschluß des Transistors 35 ist dabei mit dem die Datenausgangsleitung DO bildenden Ausgang des Inverters 33 verschaltet.

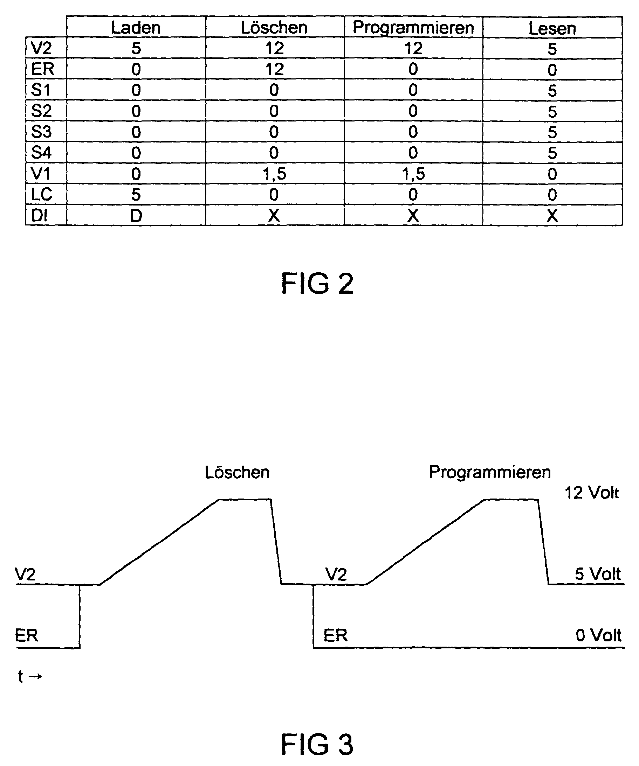

Figur 2 zeigt die auf das Bezugspotential V3 bezogenen Pegel auf der Versorgungsleitung V2, auf der Löschleitung ER, auf den Auswahlleitungen S1 bis S4, des Bezugspotentials V1, der Steuerleitung LC sowie der Dateneingangsleitung DI bei verschiedenen Betriebszuständen wie beispielsweise beim Laden, Löschen, Programmieren und Lesen. Beim Laden eines an der Datenleitung DI anliegenden Datums D in das Flip-Flop 13 tritt eine Spannung von 5 Volt gegenüber dem Bezugspotential V3 nur auf der Versorgungsleitung V2 und auf der Steuerleitung LC auf. Die Auswahlleitungen S1 bis S4, die Löschleitung ER sowie die Versorgungsleitung V1 haben dabei 0 Volt. Demgegenüber erhöht sich beim Löschen die Spannung auf der Versorgungsleitung V2 von 5 auf 12 Volt, auf der Versorgungsleitung V1 von 0 auf 1,5 Volt und auf der Löschleitung ER von 0 auf 12 Volt. Die Steuerleitung LC ändert ihren Pegel von 5 auf 0 Volt, wobei die Dateneingangsleitung DI einen beliebigen Wert X führen kann, da sie ohnehin nicht auf das Flip-Flop 13 aufgeschaltet ist. Die Auswahlleitungen S1 bis S4 bleiben auf 0 Volt.

Beim Programmieren führt die Versorgungsleitung V1 1,5 Volt und die Versorgungsleitung V2 12 Volt. Abgesehen von der Dateneingangsleitung DI mit beliebigem Pegel X haben die übrigen Leitungen 0 Volt. Beim Lesen schließlich sind bei wiederum beliebigem Pegel X auf der Dateneingangsleitung DI die Versorgungsleitung V1, die Steuerleitung LC und die Löschleitung ER auf Nullpegel, während auf der Versorgungsleitung V2 und den Auswahlleitungen S1 bis S4 ein Pegel von 5 Volt auftritt.

Über die Dateneingangsleitung DI wird also beispielsweise mit einem HIGH-Pegel an der Steuerleitung LC das Datum D in das Flip-Flop 13 eingegeben. Dabei geht gemäß Figur 3 die Versorgungsleitung V2 von LOW auf HIGH, was in diesem Falle einen Übergang von einem niedrigen Wert (zum Beispiel 5V) auf einen höheren Wert (zum Beispiel 12V) bedeutet. Die Löschleitung ER sowie die Auswahlleitungen S1 bis S4 bleiben dabei auf LOW (zum Beispiel 0V). Damit steht am Datenausgangsleitung DO das Datum bereit und kann in der Wirkung auf nachfolgende Schaltungsteile bereits geprüft werden. So können beispielsweise auf einfache Weise bei einem elektronischen Abgleich von Sensoren alle Bits nacheinander eingestellt werden, wenn für jedes Bit eine Anordnung gemäß Figur 1 verwendet wird. Beim Löschen geht demgegenüber die Löschleitung ER von 0 Volt auf 5 Volt, während der Verlauf auf der Versorgungsleitung V2 im wesentlichen dem beim Programmieren entspricht. Der Pegel über der Zeit t steigt dabei mit gegebener auf der Versorgungsleitung V2 zeitverzögert gegenüber dem rechteckigen Übergang des Pegels auf der Löschleitung ER Steigung von 5 Volt auf 12 Volt an und verharrt bei 12 Volt bis kurz vor dem nächsten Pegelübergang auf der Löschleitung ER.

Das Programmieren (d.h. nichtflüchtige Abspeichern) geschieht so, daß die MOS-Feldeffekttransistoren 1, 2, 3, 4 mit Floating-Gate auf einer Seite des Flip-Flops nichtleitend und auf der anderen Seite leitend gesteuert werden. Zum Nichtleitend machen werden die Löschleitung ER und die Versorgungsleitung V2 auf eine hohe Programmierspannung (zum Beispiel 12 Volt) gefahren, während für das Leitendmachen der Gegenseite nur die Versorgungsleitung V2 auf die hohe Programmierspannung geht und die Löschleitung ER auf Null bleibt. Welche Seite leitend und welche nichtleitend wird, hängt von der Beschaltung des Flip-Flops 13 und des in das Flip-Flop 13 eingegebenen Datums D ab. Während des Programmierens müssen die Auswahlleitungen S1 bis S4 auf Null bleiben. Nach dem Programmieren geht die Versorgungsleitung V2 auf die normale Betriebsspannung (zum Beispiel 5 Volt), während die Löschleitung ER auf Null geht bzw. auf Null bleibt.

Zum Überprüfen der Zustände der MOS-Feldeffekttransistoren 1, 2, 3, 4 mit Floating-Gate kann durch geeignete Abfolge der Auswahlleitungen S1 bis S4 und der Dateneingangsleitung DI sowie die Steuerleitung LC jeder einzelne MOS-Feldeffekttransistor 1, 2, 3, 4 mit Floating-Gate auf seinen Zustand getestet werden. Die Versorgungsleitung Vl geht während des Programmierens auf eine Spannung ein wenig über 0 Volt (zum Beispiel 1,5 Volt), um Schaltungsteile zu schonen. Die spezielle Ausgangsschaltung sorgt dafür, daß auch während des Programmierens (wegen des höheren Pegels auf der Versorgungsleitung Vl) kein Querstrom fließt und das Datum D am Ausgang erhalten bleibt.

Zudem ist es möglich, beide Seiten und damit alle MOS-Feldeffekttransistoren 1, 2, 3, 4 mit Floating-Gate leitend zu machen und diesen Zustand nach einer Lebensdauerbelastung zu testen. Die Daten können aber auch über Schieberegister eingegeben und eventuell auch mittels Schieberegister über einen anderen gemeinsamen Ausgang gelesen werden.

### Bezugszeichenliste

- 1: MOS-Feldeffekttransistor
- 2: MOS-Feldeffekttransistor
- 3: MOS-Feldeffekttransistor
- 4: MOS-Feldeffekttransistor
- 5: Tunnel-Kapazität
- 6: Tunnel-Kapazität
- 7: Tunnel-Kapazität
- 8: Tunnel-Kapazität
- 9: Auswahltransistor
- 10: Auswahltransistor
- 11: Auswahltransistor
- 12: Auswahltransistor
- 13: Flip-Flop
- 14: Injektor-Transistor
- 15: Injektor-Transistor
- 16: Injektor-Transistor
- 17: Injektor-Transistor
- 18: MOS-Feldeffekttransistoren
- 19: MOS-Feldeffekttransistoren
- 20: MOS-Feldeffekttransistoren
- 21: MOS-Feldeffekttransistoren
- 22: Schalteinrichtung
- 23: Transistor
- 24: Transistor
- 25: Transistor
- 26: Transistor
- 27: Transistor
- 28: Transistor
- 29: Inverter
- 30: Ausgangsstufe
- 31: Transistor
- 32: Transistor
- 33: Inverter
- 34: Transistor
- 35: Transistor
- B1: Bitleitung
- B2: Bitleitung
- DI: Dateneingangsleitung
- DO: Datenausgangsleitung
- ER: Löschleitung
- LC: Steuerleitung
- QP: Zustandsleitung
- QN: Zustandsleitung
- P1: Programmierleitung
- P2: Programmierleitung
- S1: Auswahlleitung
- S2: Auswahlleitung
- S3: Auswahlleitung
- S4: Auswahlleitung
- V1: Versorgungsleitung
- V2: Versorgungsleitung
- V3: Bezugspotential
- V4: Versorgungspotential

## Patentansprüche

1. Elektrisch lösch- und programmierbare nichtflüchtige Speicheranordnung mit
einer ersten elektrisch lösch- und programmierbaren nichtflüchtigen Speicherzelle (1, 5, 9, 14), die eine Bitleitung (B1), eine Auswahlleitung (S1), eine Programmierleitung (P1) und eine Löschleitung (ER) aufweist;
einer bistabilen Kippstufe (13) mit zwei zueinander inversen Zustandsleitungen (QP, QN), von denen die eine (QP) mit der Bitleitung (B1) der Speicherzelle (1, 5, 9, 14) und die andere (QN) mit Programmierleitung (P1) der Speicherzelle (1, 5, 9, 14) verbunden ist; und
einer mit der Kippstufe (13) verbundenen Schalteinrichtung (22) zum Aufschalten mindestens einer Dateneingangsleitung (DI) auf eine der Zustandsleitungen (QP, QN) der Kippstufe (13) in Abhängigkeit von einem Schaltsignal (LC).

2. Speicheranordnung nach Anspruch 1, bei der
zum Laden der Speicheranordnung die Dateneingangsleitung(en) (DI) auf die Zustandsleitung(en) (QP, QN) aufgeschaltet sind und die Kippstufe (13) mit einer niedrigen Spannung gespeist wird;
zum Löschen der Speicheranordnung die Kippstufe (13) mit einer höheren Spannung gespeist und die Löschleitung (ER) der Speicherzelle (1, 5, 9, 14) mit der höheren Spannung angesteuert wird,
zum Programmieren der Speicheranordnung die Kippstufe (13) mit der höheren Spannung gespeist wird; und
zum Lesen der Speicheranordnung die Kippstufe (13) mit der niedrigeren Spannung gespeist und die Auswahlleitung (S1) der Speicherzelle (1, 5, 9, 14) mit der niedrigeren Spannung angesteuert wird.

3. Speicheranordnung nach Anspruch 1 oder 2, bei der
eine zweite elektrisch lösch- und programmierbaren nichtflüchtige Speicherzelle (2, 6, 10, 15) vorgesehen ist;
die Bitleitung (B1) und die Löschleitung (ER) der zweiten Speicherzelle (2, 6, 10, 15) mit der Bitleitung (B1) beziehungsweise der Löschleitung (ER) der ersten Speicherzelle (1, 5, 9, 14) verbunden sind; und
die Auswahlleitung (S2) der zweiten Speicherzelle (2, 6, 10, 15) zum Laden, Löschen, Programmieren und Lesen der Speicheranordnung wie die erste Speicherzelle (1, 5, 9, 14) angesteuert wird.

4. Speicheranordnung nach Anspruch 1, 2 oder 3, bei der
mindestens eine weitere elektrisch lösch- und programmierbare nichtflüchtige Speicherzelle (3, 7, 11, 16; 4, 8, 12, 17) vorgesehen ist;
die Bitleitung (B2) und die Löschleitung (ER) der weiteren Speicherzelle(n) (3, 7, 11, 16; 4, 8, 12, 17) mit der Löschleitung (ER) beziehungsweise der Bitleitung (B1) der ersten Speicherzelle (1, 5, 9, 14) derart gekoppelt sind, daß
die Ansteuerung der weiteren Speicherzelle(n) (3, 7, 11, 16; 4, 8, 12, 17) beim Laden und Lesen der Speicheranordnung gleich der jeweiligen Ansteuerung der ersten Speicherzelle (1, 5, 9, 14) ist und beim Löschen und Programmieren der Speicheranordnung gleich der Ansteuerung der ersten Speicherzelle (1, 5, 9, 14) beim Programmieren beziehungsweise Löschen der Speicheranordnung ist.

5. Speicheranordnung nach Anspruch 3 oder 4, bei der zum Überprüfen der Zustände einzelner Speicherzellen (1, 5, 9, 14; 2, 6, 10, 15; 3, 7, 11, 16; 4, 8, 12, 17) die Auswahleitungen (S1, S2, S3, S4) dieser Speicherzellen (1, 5, 9, 14; 2, 6, 10, 15; 3, 7, 11, 16; 4, 8, 12, 17) einzeln angesteuert werden.

6. Speicheranordnung nach Anspruch 5, bei der zum Testen der Speicheranordnung durch entsprechende Ansteuerung der Dateneingangsleitungen (DI) bei entsprechendem Schaltsignal (LC) alle Speicherzellen (1, 5, 9, 14; 2, 6, 10, 15; 3, 7, 11, 16; 4, 8, 12, 17) in den gleichen Zustand gebracht werden und anschließend einzeln ausgelesen werden.

7. Speicheranordnung nach einem der vorherigen Ansprüche, bei der zum Programmieren die Auswahlleitung(en) der Speicherzelle(n) nicht angesteuert wird/werden.

8. Speicheranordnung nach einem der vorherigen Ansprüche, bei der eine Schalteinrichtung zum Aufschalten der Dateneingangsleitung(en) (DI) auf die Zustandsleitungen (QP, QN) der Kippstufe (13) vorgesehen ist, die bei Nicht-Auftreten des Schaltsignals (LC) einen hochohmigen Zustand annimmt.

9. Speicheranordnung nach einem der vorherigen Ansprüche, bei der mindestens eine Speicherzelle einen Floating-Gate-Transistor (1, 2, 3, 4) aufweist, dessen Source-Anschluß an einen Bezugspunkt (V1) angeschlossen ist, dessen Drain-Anschluß über die gesteuerte Strecke eines Auswahl-Transistors (9, 10, 11, 12) mit der Bitleitung (B1, B2) verbunden ist und dessen Gate-Anschluß zum einen über eine Tunnel-Kapazität (5, 6, 7, 8) mit der Löschleitung (ER) und zum anderen über die Gate-Source-Strecke eines Injektor-Transistors (14, 15, 16, 17) mit der Programmierleitung (P1, P2) gekoppelt ist.

10. Speicheranordnung nach einem der vorherigen Ansprüche, bei der die bistabile Kippstufe (13) und die Speicherzelle(n) (1, 5, 9, 14; 2, 6, 10, 15; 3, 7, 11, 16; 4, 8, 12, 17) einen gemeinsamen Bezugspunkt (V1) haben.

11. Speicheranordnung nach Anspruch 9 oder 10, bei der zum Löschen und Programmieren der Speicheranordnung der Bezugspunkt (V1) verschoben wird.

12. Speicheranordnung nach Anspruch 11, bei der eine an mindestens eine Zustandsleitung der Kippstufe (13) angeschlossene Ausgangsschaltung (30) vorgesehen ist, deren Querstrom sich bei Anhebung des Bezugspunkts (V1) im wesentlichen nicht erhöht.

13. Speicheranordnung nach Anspruch 11 oder 12, bei der eine Schalteinrichtung zum Aufschalten der Dateneingangsleitung(en) (DI) auf die Zustandsleitung(en) (QP, QN) der Kippstufe (13) vorgesehen ist, die Mittel (27, 28) zur Pegelwandlung und/oder Bezugspunktanpassung aufweist.
